(19) Europäisches Patentamt
European Patent Office
Office européen des brevets

(11) **EP 1 413 894 B1**

(12) **EUROPÄISCHE PATENTSCHRIFT**

(45) Veröffentlichungstag und Bekanntmachung des Hinweises auf die Patenterteilung:
**27.06.2007 Patentblatt 2007/26**

(51) Int Cl.:
**G01R 31/36** *(2006.01)*

(21) Anmeldenummer: **03020666.8**

(22) Anmeldetag: **11.09.2003**

(54) **Verfahren zur Ermittlung des Verschleisses einer Speicherbatterie und Überwachungseinrichtung**

Process for determining the deterioration of a storage battery and monitoring device

Procédé pour déterminer l'usure d'une batterie de stockage et dispositif de surveillance

(84) Benannte Vertragsstaaten:
**AT BE BG CH CY CZ DE DK EE ES FI FR GB GR HU IE IT LI LU MC NL PT RO SE SI SK TR**

(30) Priorität: **26.10.2002 DE 10249921**

(43) Veröffentlichungstag der Anmeldung:
**28.04.2004 Patentblatt 2004/18**

(73) Patentinhaber: **VB Autobatterie GmbH & Co. KGaA 30419 Hannover (DE)**

(72) Erfinder:
• **Meissner, Eberhard, Dr.**
  **31515 Wunstorf (DE)**
• **Laig-Hörstebrock, Helmut, Dr.**
  **60320 Frankfurt (DE)**
• **Tautenhahn, Wilfried, Dr.**
  **31515 Wunstorf (DE)**

(74) Vertreter: **Gerstein, Hans Joachim et al Gramm, Lins & Partner GbR Theodor-Heuss-Strasse 1 38122 Braunschweig (DE)**

(56) Entgegenhaltungen:
**US-A- 5 808 445**

**Beschreibung**

Die Erfindung betrifft ein Verfahren zur Ermittlung des Verschleißes einer Speicherbatterie durch Überwachung des Ladezustandes der Speicherbatterie.

Die Erfindung betrifft weiterhin eine Überwachungseinrichtung für Speicherbatterien mit einer Messeinheit zur Messung von den Ladezustand der Speicherbatterie kennzeichnenden Größen.

Die Erfindung betrifft weiterhin ein Computerprogramm in verkörperter Form als Erzeugnis mit Programmcodemitteln zur Durchführung ein solchen Verfahrens.

Mit zunehmender Lebensdauer von wiederaufladbaren Speicherbatterien tritt insbesondere beim Entlade- und Ladebetrieb Verschleiß auf. Neben dem Entlade- und Ladebetrieb gibt es auch andere Betriebsbedingungen, die den Verschleiß insbesondere von elektrochemischen Energiespeichern beschleunigen. Dazu gehört z. B. beim Bleiakkumulator die gesamte Betriebsdauer, d. h. die gesamte seit der Inbetriebnahme verstrichene Zeit einschließlich der Perioden, in denen der Akkumulator nicht elektrisch beaufschlagt wurde.

Weiterhin können erhöhte Temperaturen den Verschleiß während der Perioden ohne elektrische Beaufschlagung und den durch zyklischen Entlade- und Ladebetrieb hervorgerufenen Verschleiß verstärken.

Für den Einsatz von Speicherbatterien ist es erwünscht, den Verschleiß auf Grund von Verlust an Speicherkapazität zu bestimmen. Hierbei stellt jedoch die Komplexität der Vorgänge in einer Speicherbatterie ein Problem dar, die mit naturwissenschaftlichen Methoden nur schwer beschreibbar sind.

Beispielsweise aus der DE 195 40 827 C2 ist ein empirisches Verfahren zur Bestimmung des Alterungszustandes einer Speicherbatterie bekannt, bei der ein batteriespezifisches Kennfeld der Batteriealterung vorgegeben wird. Durch Erfassung von Momentanwerten der Batteriealterungseinflussgrößen bei der überwachten Speicherbatterie wird mit Hilfe des Kennfeldes ein Batteriealterungswert ermittelt.

Aus der DE 39 01 680 C3 ist ein Verfahren zur Überwachung der Kaltstartfähigkeit einer Starterbatterie bekannt, bei dem bei laufenden Verbrennungsmotor ständig die Ladespannung beobachtet und hinsichtlich des Über- oder Unterschreitens vorgegebener Grenzwerte überwacht wird. Auf diese Weise wird ein Defekt der Lichtmaschine erkannt. Zudem wird der zeitliche Verlauf des Spannungsabfalls an den Anschlussklemmen des elektrischen Anlassers während des Startvorgangs beobachtet und ausgewertet. Eine Aussage über die verfügbare Speicherkapazität der Speicherbatterie kann hierbei jedoch nicht getroffen werden.

In der DE 38 08 559 C2 ist ein Verfahren zur Überwachung der Leistungsgrenze einer Starterbatterie offenbart, bei dem durch Aufsummieren der zugeflossenen und abgeflossenen Ladungsmenge eine Ladungsmengenbilanz erstellt wird. Hieraus wird in Verbindung mit der Überwachung einer Grenz-Klemmenspannung und der Temparatur der Ladezustand der Starterbatterie bewertet. Auch hier kann keine Aussage über die verbleibende maximale Speicherkapazität des Energiespeichers getroffen werden.

In der DE 101 58 029 A1 ist ein Verfahren zum Berechnen eines dynamischen Ladezustandes einer Speicherbatterie beschrieben, bei dem Korrekturfaktoren für verschiedene Betriebsbedingungen von Strom, Temperatur und Ladezustand berücksichtigt werden. Es werden Testzyklen durchgeführt, bei dem die Speicherbatterie vollständig entladen wird. Die Anzahl der Testzyklen und die durchschnittliche Kapazitätsabnahme pro Entladungszyklus wird bestimmt und hieraus ein Ladezustandswert berechnet. Durch die vollständige Entladung wird die Kapazität der Speicherbatterie erhöht.

Die US5 808 445 beschreibt ein Verfahren zur Ermittlung der Überlastung einer Batterie mittels Aufzeichnen von Strom- und Spannungs-Werten während des Wiederaufladevorgangs.

Aufgabe der Erfindung ist es daher, ein Verfahren zur Ermittlung des Verschleißes einer Speicherbatterie durch Überwachung des Ladezustands der Speicherbatterie zu schaffen, mit dem eine Verschleißgröße als Maß für den Verlust an Speicherkapazität mit einfachen Mitteln zuverlässig berechnet werden kann.

Die Aufgabe wird mit dem gattungsgemäßen Verfahren erfindungsgemäß gelöst durch

- Erkennen von Tiefentladungs-Ereignissen, wenn ein Ladezustandswert kleiner als ein für die Speicherbatterie vorgegebener Minimalladezustandswert ist,

- Ermitteln der Dauer der erkannten Tiefentladungen, und

- Bestimmen einer den Verschleiß kennzeichnenden Verschleißgröße in derartiger Abhängigkeit von der Gesamtanzahl und der Gesamtdauer der bislang erkannten Tiefentladungen, dass die Verschleißgröße mit steigender Gesamtanzahl und steigender Gesamtdauer zunimmt.

Es wurde erkannt, dass der Verschleiß einer Speicherbatterie unmittelbar von der Anzahl und Dauer der bislang aufgetreten Tiefentladungs-Ereignisse abhängt. Eine Tiefentladung liegt dann vor, wenn aufgrund einer Entladung durch einen äußeren Stromfluss oder durch Selbstentladung der Speicherbatterie ein Ladezustand eintritt, der tiefer als z. B. der tiefste vom Hersteller der Speicherbatterie vorgesehene Ladungszustand ist. Bei einer solchen Tiefentladung kann eine zusätzliche Schädigung eintreten, die durch parasitäre Vorgänge und Reaktionen verursacht wird, die in einem höheren bzw. im zulässigen Wertebereich des Ladezustands nicht oder nur mit sehr geringer und für die Nutzung der Speicherbatterie unerheblich kleiner Rate ablaufen. Im Zustand einer Tiefentladung jedoch setzen diese parasitären Reaktionen ein oder die Reaktionsrate dieser parasitären Reaktionen steigen auf eine störende Größe an, so dass ein Verschleiß verursacht wird.

Mit dem erfindungsgemäßen Verfahren kann der Verschleiß nunmehr auf einfache Weise durch Ausnutzen der Erkenntnis bestimmt werden, dass der Verschleiß einer Speicherbatterie sich mit der Anzahl der Tiefentladungen, d. h. der Zahl der Entladevorgänge, bei denen der tiefste zulässige Ladezustand unterschritten wurde, und der Gesamtdauer sämtlicher bislang aufgetretener Tiefentladungen erhöht.

Besonders vorteilhaft ist es, die Verschleißgröße so zu bestimmen, dass sie überproportional mit der Gesamtanzahl der Tiefentladung zunimmt. Hierbei wird die weitere Erkenntnis genutzt, dass das Voranschreiten eines Verschleißes je nach Bauart der Speicherbatterie unter Umständen progressiv erfolgt. Die Bestimmung des Verschleißes basiert in diesem Fall auf dem Phänomen, dass eine eintretende Tiefentladung zu einem umso höheren Verschleiß führt, je mehr Tiefentladungen bereits insgesamt stattgefunden haben. Dieser verstärkende Effekt lässt sich durch eine Vorschädigung der Speicherbatterie durch vorangegangene Tiefentlade-Ereignisse erklären, die zu einer Verstärkung der parasitären Reaktionen führen.

In einer Ausführungsform des Verfahrens wird die Verschleißgröße vorzugsweise so bestimmt, dass sie überproportional mit der Gesamtdauer der Tiefentladungen zunimmt. Dabei wird ausgenutzt, dass sich der Verschleiß für Bauarten von Speicherbatterien mit der Gesamtdauer der Tiefentladungen, d. h. der Summe der Dauern aller eingetretenen Tiefentladungen, erhöht. Die Dauer einer Tiefentladung ist die Zeitdauer, während der die parasitären Reaktionen ablaufen. Dabei wird die Erkenntnis ausgenutzt, dass das Voranschreiten eines Verschleißes je nach Bauart der Speicherbatterie progressiv erfolgt, d. h. eine Verlängerung der Gesamtdauer der Tiefentladungen zu einem umso höheren Verschleiß führen kann, je länger die Gesamtdauer der Tiefentladungen bereits war. Dieser verstärkende Effekt lässt sich durch eine Vorschädigung durch vorangegangene Tiefentlade-Perioden erklären, die zu einer Verstärkung der parasitären Reaktionen führen.

Vorzugsweise werden zur Aufsummierung der Gesamtanzahl von Tiefentladungen nur solche Tiefentladungs-Ereignisse gewertet, deren Dauer eine definierte Minimaldauer überschreitet. Es werden also nur ausgewählte Tiefentladungen berücksichtigt, die auf Grund ihrer Länge zu einer Vorschädigung der Speicherbatterie führen.

Die definierte Minimaldauer wird dabei vorzugsweise in Abhängigkeit von der Umgebungs- oder Batterietemperatur festgelegt. Es hat sich nämlich gezeigt, dass die Wirkung von Tiefentladungen unter Umständen temperaturabhängig sein kann.

Die definierte Minimaldauer sollte im Bereich von etwa 0,1 bis 100 Stunden liegen.

Aus der so ermittelten Verschleißgröße kann dann der Verlust an Speicherfähigkeit der Speicherbatterie bestimmt werden. Hierzu wird der Verlust an Speicherfähigkeit proportional zu der ermittelten Verschleißgröße ausgehend von einer Speicherfähigkeit zu einem vorhergehenden definierten Zeitpunkt, vorzugsweise der Speicherfähigkeit der Speicherbatterie im Neuzustand, bestimmt.

Anstelle des Verlustes an Speicherfähigkeit kann aber auch eine Veränderung einer anderen Kenngröße aus der Verschleißgröße abgeleitet werden.

Vorzugsweise liegt ein von der Gesamtanzahl der erkannten Tiefentladungen abhängiger erster Verschleißanteil zur Verschleißgröße nach einer ersten Tiefentladung im Wertebereich zwischen 0,1 % und 50 %, vorzugsweise zwischen 1 % und 20 %, der Speicherfähigkeit der Speicherbatterie zu einem vorhergehenden definierten Zeitpunkt, vorzugsweise dem Neuzustand. Der Wert des von der Gesamtanzahl abhängigen ersten Verschleißanteils beträgt nach der ersten Tiefentladung bei Umgebungs- oder Batterietemparaturen von etwa 20 °C vorzugsweise 0,3 % bis 5 %.

Ein von der Gesamtdauer der erkannten Tiefentladungen abhängiger zweiter Verschleißanteil zur Verschleißgröße hat nach einer Gesamtdauer von etwa 100 Stunden vorzugsweise einen Wert zwischen 0,1 % und 100 %, vorzugsweise zwischen 0,1 % und 20 %, der Speicherfähigkeit der Speicherbatterie zu einem vorhergehenden definierten Zeitpunkt, vorzugsweise dem Neustand. Bei Umgebungs- oder Batterietemperaturen von etwa 20 °C liegt der Wert des von der Gesamtdauer abhängigen zweiten Verschleißanteils nach einer Gesamtdauer von etwa 100 Stunden vorzugsweise im Bereich von 0,3 % und 5 %.

Die genannten Werte haben sich insbesondere für Bleiakkumulatoren als geeignet herausgestellt.

Die Verschleißgröße wird dabei vorzugsweise aus der Summe eines von der Gesamtanzahl der Tiefentladungen abhängigen ersten Verschleißanteils und eines von der Gesamtdauer der Tiefentladungen abhängigen zweiten Verschleißanteils bestimmt. Dabei wird der erste Verschleißanteil aus einer ersten Funktion berechnet, die sich überproportional zu der Gesamtanzahl verhält. Der zweite Verschleißanteil wird hingegen aus einer zweiten Funktion berechnet, die sich linear oder überproportional zu der Gesamtdauer verhält. Zur Bestimmung der Verschleißgröße erfolgt somit die Berücksichtigung der Gesamtanzahl und Gesamtdauer der Tiefentladungen unabhängig voneinander durch getrennte Funktionen.

Zur Durchführung des Verfahrens ist vorzugsweise eine Überwachungseinrichtung für Speicherbatterien mit einer Messeinheit zur Messung von den Ladezustand der Speicherbatterie kennzeichnenden Größen vorgesehen. Die Überwachungseinheit hat eine vorzugsweise programmierbare prozessorgestützte Auswerteeinheit zur Bestimmung des Ladezustands der Speicherbatterie aus den gemessenen Größen und zur Ermittlung des Verschleißes der Speicherbatterie, die zur Durchführung des oben beschriebenen Verfahrens ausgebildet ist. Dies kann in für den Fachmann bekannter Weise durch Programmierung oder unter Verwendung von Logikschaltungen erfolgen.

Die Aufgabe wird weiterhin durch ein Computerprogramm in verkörperter Form als Erzeugnis mit Programmcodemitteln gelöst, wobei die Programmcodemittel zur Durchführung des oben beschriebenen Verfahrens ausgebildet sind, wenn das Computerprogramm mit Hilfe eines Mikroprozessors ausgeführt wird. Die Verkörperung des programmierten Algorithmus kann beispielsweise auf einer Diskette oder als Programmdatenstrom in einem Datennetzwerk o. ä. erfolgen.

Die Erfindung wird nachfolgend anhand der beigefügten Zeichnungen näher erläutert. Es zeigt:

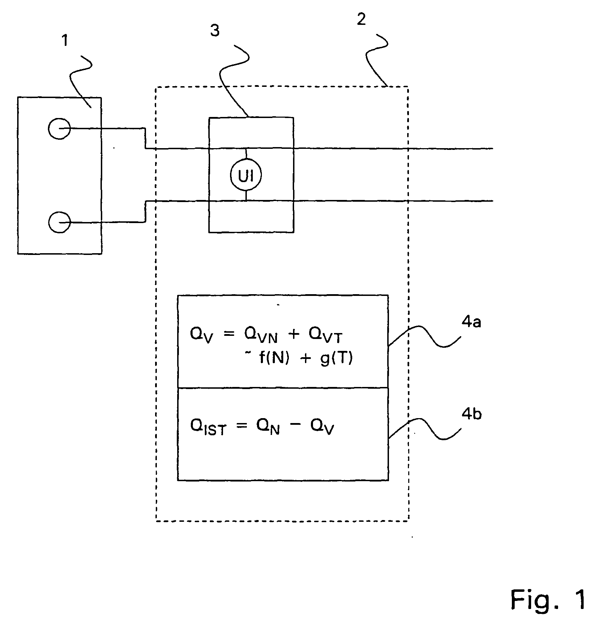

Fig.1 - Skizze einer Speicherbatterie mit einer Überwachungseinrichtung zur Messung des Ladezustands und erfindungsgemäßen Ermittlung des Verschleißes.

Die Figur 1 lässt eine Skizze einer Speicherbatterie 1 erkennen, die mit einer Überwachungseinrichtung 2 kontinuierlich während der gesamten Lebensdauer überwacht wird. Hierbei wird der Ladezustand der Speicherbatterie fortlaufend mit einer Messeinheit 3 gemessen und überprüft, ob ein Tiefentlade-Ereignis vorliegt. Ein Tiefentlade-Ereignis ist dann gegeben, wenn der Ladezustand unterhalb eines vom Hersteller der Speicherbatterie angegebenen minimalen Ladezustands ist. Insbesondere wird die Batteriespannung beobachtet und überprüft; ob die Batteriespannung unter eine definierte Minimalspannung fällt, um ein Tiefentlade-Ereignis zu erkennen.

Dann wird die Gesamtanzahl und Gesamtdauer der bislang während der Lebensdauer der Speicherbatterie aufgetretenen Tiefentladungs-Ereignisse berechnet und hieraus eine Verschleißgröße bestimmt. Der Verschleiß der Speicherbatterie 1 bzw. die entsprechende Verschleißgröße $Q_V$ nimmt hierbei mit steigender Gesamtanzahl N der erkannten Tiefentladungen und der steigenden Gesamtdauer T zu. Die Berechnung der Verschleißgröße $Q_V$ kann dabei durch Aufsummieren eines ersten Verschleißanteils $Q_{VN}$ und eines zweiten Verschleißanteils $Q_{VT}$ erfolgen, wobei der erste Verschleißanteil $Q_{VN}$ aus einer von der Gesamtanzahl N der erkannten Tiefentladungen abhängigen Funktion f(N) berechnet wird. Der zweite Verschleißanteil $Q_{VT}$ wird aus einer zweiten Funktion g(T) in Abhängigkeit von der Gesamtdauer der erkannten Tiefentladungen berechnet. Der Wert der Funktionen f(N) und g(T) steigt vorzugsweise mit zunehmender Anzahl N bzw. zunehmender Dauer T, d. h. d f(N) / d N > 0 und d g(T) / d T > 0.

Mit steigender Anzahl N der Tiefentladungen nimmt der erste Verschleißanteil $Q_{VN}$ in einer Ausführungsform progressiv zu. Die Funktion f(N) bzw. ihre Entwicklung nach der Gesamtanzahl N enthält mindestens einen Term $N^x$ mit x > 1. Die Funktion kann beispielsweise dargestellt werden als $f(N) \sim c_1 N^2$, wobei c eine Konstante ist.

Bei der Gesamtanzahl N werden allerdings nur solche Tiefentladungs-Ereignisse gewertet, deren Dauer $\tau$ eine definierte Minimal-Dauer $\tau_{min}$ überschreitet. Die definierte Minimal-Dauer $\tau_{min}$ ist vorzugsweise im Bereich zwischen 0,1 und 100 Stunden festgelegt. Die Minimal-Dauer $\tau_{min}$ sollte in Abhängigkeit von der Umgebungs- oder Batterietemperatur definiert sein und wird für eine Umgebungstemperatur von etwa 20 °C vorzugsweise zwischen 10 und 100 Stunden gewählt.

Der zweite Verschleißanteil $O_{VT}$ zur Verschleißgröße $Q_V$, der von der Gesamtdauer T der Tiefentladungs-Ereignisse abhängig ist, wird vorzugsweise durch eine Funktion g(T) berechnet, die linear oder progressiv mit der Gesamtdauer T während der Lebensdauer der Speicherbatterie erkannten Tiefentlade-Ereignisse zunimmt. Die Funktion g(T) bzw. ihre Entwicklung nach der variablen Gesamtdauer T enthält somit mindestens einen Term $T^Y$ mit $Y \geq 1$. Als vorteilhaft hat sich eine Funktion $g(T) \sim c_2 \cdot T$ mit der Konstanten $c_2$ herausgestellt, die linear mit der Gesamtdauer T anwächst.

Der erste und zweite Verschleißanteil $O_{VN}$, $Q_{VT}$ sollte in Abhängigkeit von der Batterie- oder Umgebungstemperatur berechnet werden. Dabei ist es vorteilhaft, den ersten und zweiten Verschleißanteil $Q_{VN}$ und $Q_{VT}$ auf eine Referenztemperatur, beispielsweise Raumtemperatur von 20 °C, zu normieren. Bei dieser Referenztemperatur von 20 °C sollte der Wert des ersten Verschleißanteils $Q_{VN}$ nach der ersten Tiefentladung im Bereich von 0,3 % bis 5 % liegen. Der zweite Verschleißanteil $Q_{VT}$ sollte bei der Referenztemperatur nach einer Gesamtdauer T von 100 Stunden einen Wert ebenfalls im Bereich von 0,3 % bis 5 % haben.

Die Auswerteeinheit 2 hat optional weitere Mittel, insbesondere Programmcodemittel, um aus der Verschleißgröße $Q_v = Q_{VN} + Q_{VT}$ die aktuelle Speicherfähigkeit oder auch andere die Speicherbatterie kennzeichnende Eigenschaften, die dem Verschleiß unterliegen, zu ermitteln. Hierzu wird die Verschleißgröße $Q_v$ gegebenenfalls multipliziert mit einem Faktor von der Anfangskapazität $Q_N$ der Speicherbatterie im Neuzustand subtrahiert:

$$Q_{ist} = Q_N - c_3 Q_V,$$

mit $c_3$ als konstanter Proportionalitätsfaktor. Die Verschleißgröße $Q_v$ ist somit ein direktes Maß für den Verlust an Speicherfähigkeit der Speicherbatterie.

Das Verfahren kann mit weiteren Methoden zur Verschleißermittlung verknüpft werden, die möglicherweise weitere zum Verschleiß von Speicherbatterien beitragende physikalische Effekte als die Tiefentladung berücksichtigen. Die aktuelle Speicherfähigkeit $Q_{ist}$ wird

dann aus der Anfangskapazität $Q_N$ der Speicherbatterie im Neuzustand und der verknüpften Verschleißgröße $Q^*_V$ berechnet durch:

$$Q_{ist} = Q_N - c_4 \bullet Q^*_V,$$

wobei $c_4$ ein konstanter Proportionalitätsfaktor ist.

**Patentansprüche**

1. Verfahren zur Ermittlung des Verschleißes einer Speicherbatterie durch Überwachung des Ladezustands der Speicherbatterie, **gekennzeichnet durch**

   - Erkennen von Tiefentladungs-Ereignissen, wenn ein Ladezustandswert kleiner als ein für die Speicherbatterie vorgegebener Minimal-Ladezustandswert ist,
   - Ermitteln der Dauer ($\tau$) der erkannten Tiefentladungen, und
   - Bestimmen einer den Verschleiß kennzeichnenden Verschleißgröße ($Q_V$) in derartiger Abhängigkeit von der Gesamtanzahl (N) und der Gesamtdauer (T) der bislang erkannten Tiefentladungen, dass die Verschleißgröße ($Q_V$) mit steigender Gesamtanzahl (N) und steigender Gesamtdauer (T) zunimmt.

2. Verfahren nach Anspruch 1, **gekennzeichnet durch** Bestimmen der Verschleißgröße ($Q_V$) derart, dass die Verschleißgröße ($Q_V$) überproportional mit der Gesamtanzahl (N) der Tiefentladungen zunimmt.

3. Verfahren nach Anspruch 1 oder 2, **gekennzeichnet durch** Bestimmen der Verschleißgröße ($Q_V$) derart, dass die Verschleißgröße (Q) überproportional mit der Gesamtdauer (T) der Tiefentladungen zunimmt.

4. Verfahren nach einem der vorhergehenden Ansprüche, **dadurch gekennzeichnet, dass** zur Aufsummierung der Gesamtanzahl (N) nur solche Tiefentladungs-Ereignisse gewertet werden, deren Dauer ($\tau$) eine festgelegte Minimal-Dauer ($\tau_{min}$) überschreitet.

5. Verfahren nach Anspruch 4, **dadurch gekennzeichnet, dass** die festgelegte Minimaldauer ($\tau_{min}$) in Abhängigkeit von der Umgebungs- oder Batterietemparatur festgelegt ist.

6. Verfahren nach Anspruch 4 oder 5, **dadurch ge-**

**kennzeichnet, dass** die festgelegte Minimal-Dauer ($\tau_{min}$) bei Raumtemperatur im Bereich von 0,1 bis 100 Stunden festgelegt wird.

7. Verfahren nach einem der vorhergehenden Ansprüche, **gekennzeichnet durch** Bestimmen eines Verlustes an Speicherfähigkeit ($Q_N$) der Speicherbatterie proportional zu der ermittelten Verschleißgröße ($Q_V$) ausgehend von einer Speicherfähigkeit ($Q_{Neu}$) zu einem vorhergehenden definierten Zeitpunkt.

8. Verfahren nach Anspruch 7, **dadurch gekennzeichnet, dass** die Speicherfähigkeit ($Q_{Neu}$) zu dem vorhergehenden definierten Zeitpunkt die Speicherfähigkeit ($C_{Neu}$) der Speicherbatterie im Neuzustand ist und dass die Verschleißgröße ($Q_V$) zu dem definierten Zeitpunkt auf Null gesetzt wird.

9. Verfahren nach Anspruch 7 oder 8, **gekennzeichnet durch** Bestimmen eines von der Gesamtanzahl (N) der erkannten Tiefentladungen abhängigen ersten Verschleißanteils ($Q_{VN}$) zur Verschleißgröße ($Q_V$) nach einer ersten Tiefentladung auf einen Wert zwischen 0,1 % und 50 %, vorzugsweise zwischen 1 % und 20 %, der Speicherfähigkeit ($Q_{Neu}$) der Speicherbatterie zu dem vorhergehenden definierten Zeitpunkt.

10. Verfahren nach Anspruch 9, **gekennzeichnet durch** Bestimmen des Wertes des von der Gesamtanzahl (N) abhängigen ersten Verschleißanteils ($Q_{VN}$) nach der ersten Tiefentladung bei Umgebungs- oder Batterietemperaturen auf einem Wert im Bereich von 20 °C zwischen 0,3 % bis 5 %.

11. Verfahren nach einem der Ansprüche 8 bis 10, **gekennzeichnet durch** Bestimmen eines von der Gesamtdauer (T) der erkannten Tiefentladungen abhängigen zweiten Verschleißanteils ($Q_{VT}$) zur Verschleißgröße ($Q_V$) nach einer Gesamtdauer (T) von 100 Stunden auf einen Wert zwischen 01, % und 100 %, vorzugsweise zwischen 0,1 % und 20 %, der Speicherfähigkeit ($Q_{Neu}$) der Speicherbatterie zu dem vorhergehenden definierten Zeitpunkt.

12. Verfahren nach Anspruch 11, **gekennzeichnet durch** Bestimmen des Wertrs des von der Gesamtdauer (T) abhängigen zweiten Verschleißanteils ($Q_{VT}$) nach einer Gesamtdauer (T) von 100 Stunden bei Umgebungs- oder Batterietemparaturen im Bereich von 20 °C zwischen 0,3 % und 5 %.

13. Verfahren nach einem der vorhergehenden Ansprüche, **gekennzeichnet durch** Bestimmen der Verschleißgröße ($Q_V$) aus der Summe eines von der Gesamtanzahl (N) der Tiefentladungen abhängigen ersten Verschleißanteils ($Q_{VN}$) und eines von der Gesamtdauer (T) der Tiefentladungen abhängigen zweiten Verschleißanteils ($Q_{VT}$), wobei der erste Verschleißanteil ($Q_{VN}$) aus einer ersten Funktion (f (N)) berechnet wird, die sich linear oder überproportional zu der Gesamtanzahl N verhält und der zweite Verschleißanteil ($Q_{VT}$) aus einer zweiten Funktion (g(T)) berechnet wird, die sich linear oder überproportional zu der Gesamtdauer (T) verhält.

14. Überwachungseinrichtung für Speicherbatterien mit einer Messeinheit zur Messung von den Ladezustand der Speicherbatterie kennzeichnenden Größen, **gekennzeichnet durch** eine Auswerteeinheit zur Bestimmung des Ladezustands der Speicherbatterie aus den gemessenen Größen und Ermittlung des Verschleißes der Speicherbatterie mit dem Verfahren nach einem der vorhergehenden Ansprüche.

15. Computerprogramm mit Programmcodemitteln, **dadurch gekennzeichnet, dass** die Programmcodemittel zur Durchführung aller Schritte des Verfahrens nach einem der vorhergehenden Ansprüche ausgebildet ist, wenn das Computerprogramm mit Hilfe eines Mikroprozessors ausgeführt wird.

**Claims**

1. Method for determining the wear to a storage battery by monitoring the state of charge of the storage battery **characterized by**

    - identifying deep discharge events, when a state of charge value is less than a minimum state of charge value predetermined for the storage battery,
    - determining the duration ($\tau$) of the identified deep discharge events, and
    - determining a wear variable ($Q_V$), which characterizes the wear as a function of the total number (N) and the total duration (T) of the actually identified deep discharge events such that the wear variable ($Q_V$) increases as the total number (N) and the total duration (T) increase.

2. Method according to claim 1, **characterized by** determining the wear variable ($Q_V$) such that the wear variable ($Q_V$) increases non-linearly with and at a greater rate than the total number (N) of the deep discharge events.

3. Method according to claim 1 or 2, **characterized by** determining the wear variable ($Q_V$) such that the wear variable (Q) increases non-linearly and at a greater rate than the total duration (T) of the deep discharge events.

4. Method according to one of the preceding claims **characterized in that** for summation of the total number (N) only such deep discharge events are assessed, the duration ($\tau$) of which exceeds a defined minimum duration ($\tau_{min}$).

5. Method according to claim 4, **characterized in that** the defined minimum duration ($\tau_{min}$) is defined as a function of the ambient temperature or the battery temperature.

6. Method according to claim 4 or 5, **characterized in that** the defined minimum duration ($\tau_{min}$) is defined in the range of 0,1 to 100 hours at room temperature.

7. Method according to one of the preceding claims, **characterized by** determining a loss of storage capability ($Q_N$) of the storage battery in proportion to the determined wear variable ($Q_V$) based on a storage capacity ($Q_{NEU}$) at a previous defined time.

8. Method according to claim 7, **characterized in that** the storage capacity ($Q_{NEU}$) at the previous defined time is the storage capacity ($Q_{NEU}$) of the storage battery, when the storage battery was new, and that the wear variable ($Q_V$) at the defined time is set to zero.

9. Method according to claim 7 or 8 **characterized by** determining a first wear component ($Q_{VN}$) of the wear variable ($Q_v$) that is dependent on the total number (N) of identified deep discharge events of a value between 0.1 % and 50 %, preferably between 1 % and 20 % of the storage capacity ($Q_{Neu}$) of the storage battery after a first deep discharge event at the previous defined time.

10. Method according to claim 9, **characterized by** determining the value of the first wear component ($Q_{VN}$) that is dependent on the total number (N), of between 0.3 % to 5 % after the first deep discharge event at an ambient temperature or the battery temperature in the range of 20°C.

11. Method according to claim 8 to 10, **characterized by** determining a second wear component ($Q_{VT}$) of the wear variable ($Q_v$) that is dependent on the total duration (T) of identified deep discharge events $\tau$ of a value between 0.1 % and 100 %, preferably between 0.1 % and 20 %, of the storage capacity ($Q_{Neu}$) of the storage battery after a total duration (T) of 100 hours at the previous defined time.

12. Method according to claim 11, **characterized by** determining the value of the second wear component ($Q_{VT}$) that is dependent on the total duration (T) of between 0.3 % and 5 % after a total duration (T) of 100 hours at an ambient temperature or battery temperature in the range of 20°C.

**13.** Method according to one of the preceding claims, **characterized by** determining the wear variable ($Q_V$) from the sum of a first wear component ($Q_{VN}$) that is dependent on the total number (N) of deep discharge events and a second wear component ($Q_{VT}$) that is dependent on the total duration (T) of the deep discharge events, wherein the first wear component ($Q_{VN}$) is calculated from a first function (f(N)) that behaves linearly or disproportionately with regard to the total number (N), and the second wear component (($Q_{VT}$) is calculated from a second function (g(T)) that behaves linearly or disproportionately with regard to the total duration (T).

**14.** Monitoring device for storage batteries comprising a measurement unit for measuring variables which characterize the state of charge of the storage battery, **characterized by** an evaluation unit for determining the state of charge of the storage battery from the measured variables and for determining the wear of the storage battery by the method according to one of the preceding claims.

**15.** Computer program comprising program code means **characterized in that** the program code means are designed to carry out all steps of the method according to one of the preceding claims, if the computer program is executed with the aid of a microprocessor.

**Revendications**

**1.** Procédé permettant de déterminer l'usure d'une batterie par la surveillance de l'état de charge de la batterie, **caractérisé en ce que**

- onreconnait des évènements de décharge totale, si une valeur d'état de charge est inférieure à une valeur d'état de charge minimale prédéterminée pour la batterie,
- on détermine la durée ($\tau$) des décharges totales identifiées, et
- on détermine une grandeur d'usure ($Q_v$) caractérisant l'usure en fonction du nombre global (N) et de la durée globale (T) des décharges totales identifiées jusqu'alors, fonction telle que la grandeur d'usure (Q) augmente avec un nombre global croissant (N) et une durée globale croissante (T).

**2.** Procédé selon la revendication 1, **caractérisé par** la détermination de la grandeur d'usure ($Q_v$) de sorte que la grandeur d'usure ($Q_v$) augmente de façon plus que proportionnelle au nombre global (N) des décharges totales.

**3.** Procédé selon la revendication 1 ou 2, **caractérisé par** la détermination de la grandeur d'usure ($Q_v$) de sorte que la grandeur d'usure (Q) augmente de façon plus que proportionnelle à la durée globale (T) des décharges totales.

**4.** Procédé selon l'une quelconque des revendications précédentes, **caractérisé en ce que** seuls sont évalués les évènements de décharge totale dont la durée ($\tau$) dépasse une durée minimum déterminée ($\tau_{min}$) pour faire le total du nombre global (N).

**5.** Procédé selon la revendication 4, **caractérisé en ce que** la durée minimum ($\tau_{min}$) déterminée est déterminée en fonction de la température ambiante ou de la température de la batterie.

**6.** Procédé selon la revendication 4 ou 5, **caractérisé en ce que** la durée minimum ($\tau_{min}$) déterminée à température ambiante est fixée dans la plage de 0,1 à 100 heures.

**7.** Procédé selon l'une quelconque des revendications précédentes, **caractérisé par** la détermination d'une perte de capacité d'accumulation ($Q_N$) de la batterie proportionnelle à la grandeur d'usure déterminée ($Q_v$) sur la base d'une capacité d'accumulation ($Q_{Neu}$) à un moment défini précédent.

**8.** Procédé selon la revendication 7, **caractérisé en ce que** la capacité d'accumulation ($Q_{Neu}$) au moment défini précédent est la capacité d'accumulation ($Q_{Neu}$) de la batterie dans le nouvel état et la grandeur d'usure ($Q_v$) est placée à zéro au moment défini.

**9.** Procédé selon la revendication 7 ou 8, **caractérisé par** la détermination d'une première proportion d'usure ($Q_{VN}$) dépendant du nombre global (N) des décharges totales identifiées pour la grandeur d'usure ($Q_v$) après une première décharge totale à une valeur située entre 0,1 % et 50 %, de préférence entre 1 % et 20 %, de la capacité d'accumulation ($Q_{Neu}$) de la batterie au moment défini précédent.

**10.** Procédé selon la revendication 9, **caractérisé par** la détermination de la valeur de la première proportion d'usure ($Q_{VN}$) dépendant du nombre global (N) après la première décharge totale pour les températures ambiantes ou les températures de la batterie à une valeur située dans la plage de 20 °C entre 0,3 % à 5 %.

**11.** Procédé selon la revendication 8 à 10, **caractérisé par** la détermination d'une seconde proportion d'usure ($Q_{VT}$) dépendant de la durée globale (T) des décharges totales identifiées pour la grandeur d'usure ($Q_v$) après une période globale (T) de 100 heures à une valeur située entre 0,1 % et 100 %, de préférence entre 0,1 % et 20 % de la capacité d'accumulation ($Q_{Neu}$) de la batterie au moment défini précédent.

**12.** Procédé selon la revendication 11, **caractérisé par** la détermination de la valeur de la seconde proportion d'usure ($Q_{VT}$) dépendant de la durée globale (T) après une durée globale (T) de 100 heures pour les températures ambiantes ou les températures de la batterie dans la plage de 20 °C entre 0,3 % et 5 %.

**13.** Procédé selon l'une quelconque des revendications précédentes, **caractérisé par** la détermination de la grandeur d'usure ($Q_v$) à partir du total d'une première proportion d'usure ($Q_{VN}$) dépendant du nombre global (N) des décharges totales, et d'une seconde proportion d'usure ($Q_{VT}$) dépendant de la durée globale (T) des décharges totales, selon lequel on calcule la première proportion d'usure ($Q_{VN}$) à partir d'une première fonction (f(N)) qui se comporte de façon linéaire ou de façon plus que proportionnelle au nombre global N, et on calcule la seconde proportion d'usure ($Q_{VT}$) à partir d'une seconde fonction (g(T)) qui se comporte de façon linéaire ou de façon plus que proportionnelle à la durée globale (T).

**14.** Dispositif de surveillance pour des batteries avec une unité de mesure permettant de mesurer l'état de charge de la grandeur caractérisant la batterie, **caractérisé par** une unité d'exploitation permettant de déterminer l'état de charge de la batterie à partir des grandeurs mesurées et de déterminer l'usure de la batterie avec le procédé selon l'une quelconque des revendications précédentes.

**15.** Programme informatique avec des moyens de code de programmation, **caractérisé en ce que** les moyens de code de programmation permettent de mettre en oeuvre toutes les étapes du procédé selon l'une quelconque des revendications précédentes, si le programme informatique est réalisé à l'aide d'un microprocesseur.

$$Q_V = Q_{VN} + Q_{VT}$$
$$\sim f(N) + g(T)$$

$$Q_{IST} = Q_N - Q_V$$

Fig. 1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 19540827 C2
- DE 3901680 C3
- DE 3808559 C2
- DE 10158029 A1
- US 5808445 A